# EUROPEAN PATENT APPLICATION

(11) **EP 2 381 012 A1**
(43) Date of publication of application: **26.10.2011**
(21) Application number: 11163131.3
(22) Date of filing: 20.04.2011
(51) Int. Cl.: C23C 14/56

(54) **Modular system for high-rate deposition of thin film layers on photovoltaic module substrates**

(30) Priority: 22.04.2010 US 765295
(71) Applicant: PrimeStar Solar, Inc, Arvada, CO 80004 (US)
(72) Inventor: Black, Russell Weldon, Arvada, CO 80004 (US); Murphy, Brian Robert, Golden Colorado, CO 80401 (US)
(74) Representative: Bedford, Grant Richard

(57) **Abstract**

A system (100) and related method for deposition of multiple thin film layers on photovoltaic (PV) module substrates (12) includes a first processing side (102) wherein the substrates are conveyed in a first direction (103) for deposition of a first thin film layer on the substrates. A second processing side (110) is operably disposed relative to the first processing side such that substrates exiting the first processing side are subsequently conveyed in a second direction (111) through the second processing side for deposition of a second thin film layer on the first thin film layer. A first transfer station (118) is operably disposed between the first processing side and the second processing side to receive the substrates from an exit (108) of the first processing side and to introduce the substrates into an entry (114) of the second processing side such that the substrates are continuously moved through the first and second processing sides for deposition of multiple thin film layers thereon.

## Description

The subject matter disclosed herein relates generally to a system for deposition of thin films on a substrate, and more particularly to a high throughput system for deposition of multiple thin film layers on photovoltaic module substrates.

Thin film photovoltaic (PV) modules (also referred to as "solar panels" or "solar modules") are gaining wide acceptance and interest in the industry, particularly modules based on cadmium telluride (CdTe) paired with cadmium sulfide (CdS) as the photo-reactive components. CdTe is a semiconductor material having characteristics particularly suited for conversion of solar energy (sunlight) to electricity. For example, CdTe has an energy bandgap of 1.45 eV, which enables it to convert more energy from the solar spectrum as compared to lower bandgap (1.1eV) semiconductor materials historically used in solar cell applications. Also, CdTe converts energy more efficiently in lower or diffuse light conditions as compared to the lower bandgap materials and, thus, has a longer effective conversion time over the course of a day or in low-light (e.g., cloudy) conditions as compared to other conventional materials.

Typically, CdTe PV modules include multiple film layers deposited on a glass substrate before deposition of the CdTe layer. For example, a transparent conductive oxide (TCO) layer is first deposited onto the surface of the glass substrate, and a resistive transparent buffer (RTB) layer is then applied on the TCO layer. The RTB layer may be a zinc-tin oxide (ZTO) layer and may be referred to as a "ZTO layer." A cadmium sulfide (CdS) layer is applied on the RTB layer. These various layers may be applied in a conventional sputtering deposition process that involves ejecting material from a target (i.e., the material source), and depositing the ejected material onto the substrate to form the film.

Solar energy systems using CdTe PV modules are generally recognized as the most cost efficient of the commercially available systems in terms of cost per watt of power generated. However, the advantages of CdTe not withstanding, sustainable commercial exploitation and acceptance of solar power as a supplemental or primary source of industrial or residential power depends on the ability to produce efficient PV modules on a large scale and in a cost effective manner. The capital costs associated with production of PV modules, particularly the machinery and time needed for deposition of the multiple thin film layers discussed above, is a primary commercial consideration.

Accordingly, there exists an ongoing need in the industry for an improved system for economically feasible and efficient large scale production of PV modules, particularly CdTe based modules.

Various aspects and advantages of the invention will be set forth in part in the following description, or may be clear from the description, or may be learned through practice of the invention.

Embodiments in accordance with aspects of the invention include a system for deposition of multiple thin film layers on photovoltaic (PV) module substrates. The system includes a first processing side wherein the substrates are conveyed in a first direction, with the first processing side including processing stations configured for deposition of a first thin film layer on the substrates. The processing stations may include modular units serially aligned to carry out all of the processing steps necessary for deposition of the first film layer. The system includes a second processing side operably disposed relative to the first processing side such that substrates exiting the first processing side are subsequently conveyed in a second direction through the second processing side. The second processing side includes processing stations configured for deposition of a second thin film layer on the first thin film layer. As with the first processing side, the second processing side may include modular units configured for carrying out all of the steps necessary for deposition of the second thin film layer. A transfer station is operably disposed between the first processing side and the second processing side to receive the substrates from an exit of the first processing side and to introduce the substrates into an entry of the second processing side. Any manner of automated transfer device, such as a turntable system, robotic machinery, and the like, may be utilized at the transfer station. In this manner, a continuous supply of substrates can be moved serially through the first and second processing sides for deposition of multiple thin film layers thereon.

In a particularly unique embodiment, the substrates are loaded onto carriers that are conveyed through the system, with the carriers configured for holding two or more of the substrates. A load station and an unload station are provided in the system for loading the substrates into and removing the substrates from the carriers. The first and second processing sides may include driven conveyors that engage and move the carriers in a controlled manner through the system.

In still a further unique embodiment, the carriers and attached substrates are conveyed in a vertical orientation through the first and second processing sides, with the respective processing stations along the first and second processing sides including vertical processing modules. For example, vertical deposition modules along the first processing side may define a vacuum sputtering chamber for deposition of a desired thin film layer, such as a zinc-tin oxide (ZTO) layer, and vertical deposition modules along the second processing side may define a vacuum sputtering chamber for deposition of a second type of thin film layer, such as a cadmium sulfide (CdS) layer.

The system may be set up in various operational configurations. For example, in one embodiment, the system may define a continuous loop with the first and second processing sides being generally parallel to each other and with transfer stations at the respective ends of the processing sides. In this configuration, the carriers may be conveyed in a continuous loop through the system, with the substrates being loaded and unloaded at respective load and unload stations provided in the continuous loop. In another embodiment, the system may be designed as a single turn or open-loop system wherein the carriers are loaded into the first processing side and removed at the end of the second processing side.

Variations and modifications to the system embodiments discussed above are within the scope and spirit of the invention and may be further described herein.

The invention also encompasses various process embodiments for deposition of multiple thin film layers on a photovoltaic (PV) module substrate. The process includes conveying one or more of the substrates on carriers in a first direction through a first processing side and depositing a first thin film layer on the substrates as they move through the first processing side. The carriers and attached substrates are received at an exit of the first processing side and are moved to an entry of a second processing side. The carriers and attached substrates are conveyed in a second direction through the second processing side wherein a second thin film layer is deposited on the first thin film layer. The substrates are removed from the carriers at an unload station downstream of an exit from the second processing side, and new substrates are placed on the carriers at a load station downstream of the unload station and upstream of an entry to the first processing side. The method is not limited to deposition of any particular thin film layer.

In a particular embodiment, the process may be conducted in a continuous loop wherein the carriers are conveyed continuously around the first and second processing sides, with the unload and load stations being adjacent locations within the loop.

In a different embodiment, the first and second processing sides are generally parallel and the carriers are loaded at an entry to the first processing side and removed at an exit of the second processing side.

The process may include deposition of the thin film layers within vacuum chambers defined along the first and second processing sides, wherein the carriers and attached substrates are moved into and out of the vacuum chambers in a step-wise manner and conveyed through the vacuum chambers at a continuous linear speed.

The process may be conducted with various known deposition methods and systems within the first and second processing sides. For example, the carriers and attached substrates may be vertically oriented and conveyed through the processing sides. The first processing side may deposit a first thin film layer, such as a zinc tin oxide (ZTO) layer, on the substrates in a vertical planar sputtering process, and the second processing side may deposit a different thin film layer, such as a cadmium sulfide (CdS) layer, on the ZTO layer in a vertical planar sputtering process. The thin film layers may be deposited within vacuum chambers defined along the first and second processing stations, with the process further comprising moving the carriers and attached substrates into and through the vacuum chambers without breaking vacuum between the first and second processing sides.

Variations and modifications to the process discussed above are within the scope and spirit of the invention and may be further described herein.

Various features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention. In the drawings:
Fig. 1 is a cross-sectional view of a CdTe photovoltaic module;
Fig. 2 shows a top plan view of an exemplary system in accordance with aspects of the invention;
Fig. 3 shows a top plan view of an alternative system in accordance with aspects of the invention;
Fig. 4 is a perspective view of an embodiment of a substrate carrier configuration;
Fig. 5 is a perspective view of an alternative embodiment of a substrate carrier configuration;
Fig. 6 is diagrammatic view of an embodiment of a sputtering chamber for deposition of a thin film on a substrate; and,
Fig. 7 is a diagrammatic view of an alternative embodiment of a sputtering chamber.

Repeat use of reference characters in the present specification and drawings is intended to represent the same or analogous features or elements.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment can be used with another embodiment to yield a still further embodiment. Thus, it is intended that the present invention covers such modifications and variations as come within the scope of the appended claims and their equivalents.

In the present disclosure, when a layer is described as "on" or "over" another layer or substrate, it is to be understood that the layers can either be directly contacting each other or have another layer or feature between the layers. Thus, these terms are simply describing the relative position of the layers to each other and do not necessarily mean "on top of" since the relative position above or below depends upon the orientation of the device to the viewer. Additionally, although embodiments of the invention are not limited to any particular film thickness, the term "thin" describing any film layers of the photovoltaic device generally refers to the film layer having a thickness less than about 10 micrometers ("microns" or "µm").

It is to be understood that the ranges and limits mentioned herein include all ranges located within the prescribed limits (i.e., subranges). For instance, a range from about 100 to about 200 also includes ranges from 110 to 150, 170 to 190, 153 to 162, and 145.3 to 149.6. Further, a limit of up to about 7 also includes a limit of up to about 5, up to 3, and up to about 4.5, as well as ranges within the limit, such as from about 1 to about 5, and from about 3.2 to about 6.5.

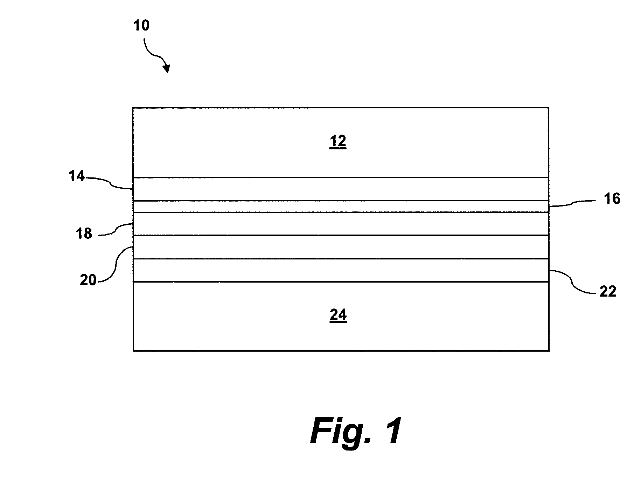

As mentioned, the present system and method have particular usefulness for deposition of multiple thin film layers in the manufacture of PV modules, especially CdTe modules. Fig. 1 represents an exemplary CdTe module 10 that can be made at least in part according to system and method embodiment described herein. The module 10 includes a top sheet of glass as the substrate 12, which may be a high-transmission glass (e.g., high transmission borosilicate glass), low-iron float glass, or other highly transparent glass material. The glass is generally thick enough to provide support for the subsequent film layers (e.g., from about 0.5 mm to about 10 mm thick), and is substantially flat to provide a good surface for forming the subsequent film layers.

A transparent conductive oxide (TCO) layer 14 is shown on the substrate 12 of the module 10 in Fig. 1. The TCO layer 14 allows light to pass through with minimal absorption while also allowing electric current produced by the module 10 to travel sideways to opaque metal conductors (not shown). The TCO layer 14 can have a thickness between about 0.1 µm and about 1 µm, for example from about 0.1 µm to about 0.5 µm, such as from about 0.25 µm to about 0.35 µm.

A resistive transparent buffer (RTB) layer 16 is shown on the TCO layer 14. This layer 16 is generally more resistive than the TCO layer 14 and can help protect the module 10 from chemical interactions between the TCO layer 14 and the subsequent layers during processing of the module 10. In certain embodiments, the RTB layer 16 can have a thickness between about 0.075 µm and about 1 µm, for example from about 0.1 µm to about 0.5 µm. In particular embodiments, the RTB layer 16 can have a thickness between about 0.08 µm and about 0.2 µm, for example from about 0.1 µm to about 0.15 µm. In particular embodiments, the RTB layer 16 can include, for instance, a combination of zinc oxide (ZnO) and tin oxide (SnO₂) and is referred to as a zinc-tin oxide ("ZTO") layer 16.

The ZTO layer 16 can be formed by sputtering, chemical vapor deposition, spraying pryolysis, or any other suitable deposition method. In particular embodiments, the ZTO layer 16 is formed by sputtering (e.g. DC sputtering or RF sputtering) on the TCO layer 14. For example, the layer 16 can be deposited using a DC sputtering method by applying a DC current to a metallic source material (e.g., elemental zinc, elemental tin, or a mixture thereof) and sputtering the metallic source material onto the TCO layer 14 in the presence of an oxidizing atmosphere (e.g., O₂ gas).

The CdS layer 18 is shown on ZTO layer 16 of the module 10 of Fig. 1. The CdS layer 18 is a n-type layer that generally includes cadmium sulfide (CdS) but may also include other materials, such as zinc sulfide, cadmium zinc sulfide, etc., and mixtures thereof, as well as dopants and other impurities. The CdS layer 18 may include oxygen up to about 25% by atomic percentage, for example from about 5% to about 20% by atomic percentage. The CdS layer 18 can have a wide band gap (e.g., from about 2.25 eV to about 2.5 eV, such as about 2.4 eV) in order to allow most radiation energy (e.g., solar radiation) to pass. As such, the cadmium sulfide layer 18 is considered a transparent layer on the device 10.

The CdS layer 18 can be formed by sputtering, chemical vapor deposition, chemical bath deposition, or any other suitable deposition method. In one particular embodiment, the CdS layer 18 is formed by sputtering (e.g., radio frequency (RF) sputtering) onto the RTB layer 16, and can have a thickness that is less than about 0.1 µm. This decreased thickness of less than about 0.1 µm reduces absorption of radiation energy by the CdS layer 18, effectively increasing the amount of radiation energy reaching the underlying CdTe layer 20.

The CdTe layer 20 is shown on the cadmium sulfide layer 18 in the exemplary module 10 of Fig. 1. The layer 20 is a p-type layer that generally includes cadmium telluride (CdTe), but may also include other materials. As the p-type layer of the module 10, the CdTe layer 20 is the photovoltaic layer that interacts with the CdS layer 18 (i.e., the n-type layer) to produce current from the absorption of radiation energy by absorbing the majority of the radiation energy passing into the module 10 due to its high absorption coefficient and creating electron-hole pairs. The CdTe layer 20 can have a bandgap tailored to absorb radiation energy (e.g., from about 1.4 eV to about 1.5 eV, such as about 1.45 eV) to create the maximum number of electron-hole pairs with the highest electrical potential (voltage) upon absorption of the radiation energy. Electrons may travel from the p-type side (i.e., the CdTe layer 20) across the junction to the n-type side (i.e., the CdS layer 18) and, conversely, holes may pass from the n-type side to the p-type side. Thus, the p-n junction formed between the CdTe layer 18 and the CdTe layer 20 forms a diode in which the charge imbalance leads to the creation of an electric field spanning the p-n junction. Conventional current is allowed to flow in only one direction and separates the light induced electron-hole pairs.

The cadmium telluride layer 20 can be formed by any known process, such as vapor transport deposition, chemical vapor deposition (CVD), spray pyrolysis, electrodeposition, sputtering, close-space sublimation (CSS), etc. In particular embodiments, the CdTe layer 20 can have a thickness between about 0.1 µm and about 10 µm, such as from about 1 µm and about 5 µm.

A series of post-forming treatments can be applied to the exposed surface of the CdTe layer 20. These treatments can tailor the functionality of the CdTe layer 20 and prepare its surface for subsequent adhesion to the back contact layer(s) 22. For example, the cadmium telluride layer 20 can be annealed at elevated temperatures (e.g., from about 350° C to about 500° C, such as from about 375° C to about 424° C) for a sufficient time (e.g., from about 1 to about 10 minutes) to create a quality p-type layer of cadmium telluride. Without wishing to be bound by theory, it is believed that annealing the cadmium telluride layer 20 (and the module 10) converts the normally lightly p-type doped, or even n-type doped CdTe layer 20 to a more strongly p-type layer having a relatively low resistivity. Additionally, the CdTe layer 20 can recrystallize and undergo grain growth during annealing.

Additionally, copper can be added to the CdTe layer 20. Along with a suitable etch, the addition of copper to the CdTe layer 20 can form a surface of copper-telluride (Cu₂Te) on the CdTe layer 20 in order to obtain a low-resistance electrical contact between the cadmium telluride layer 20 (i.e., the p-type layer) and a back contact layer(s) 22.

The back contact layer 22 generally serves as the back electrical contact, in relation to the opposite, TCO layer 14 serving as the front electrical contact. The back contact layer 22 can be formed on, and in one embodiment is in direct contact with, the CdTe layer 20. The back contact layer 22 is suitably made from one or more highly conductive materials, such as elemental nickel, chromium, copper, tin, aluminum, gold, silver, technetium or alloys or mixtures thereof. Additionally, the back contact layer 22 can be a single layer or can be a plurality of layers. In one particular embodiment, the back contact layer 22 can include graphite, such as a layer of carbon deposited on the p-layer followed by one or more layers of metal, such as the metals described above. The back contact layer 22, if made of or comprising one or more metals, is suitably applied by a technique such as sputtering or metal evaporation. If it is made from a graphite and polymer blend, or from a carbon paste, the blend or paste is applied to the semiconductor device by any suitable method for spreading the blend or paste, such as screen printing, spraying or by a "doctor" blade. After the application of the graphite blend or carbon paste, the device can be heated to convert the blend or paste into the conductive back contact layer. A carbon layer, if used, can be from about 0.1 µm to about 10 µm in thickness, for example from about 1 µm to about 5 µm. A metal layer of the back contact, if used for or as part of the back contact layer 22, can be from about 0.1 µm to about 1.5 µm in thickness.

In the embodiment of Fig. 1, an encapsulating glass 24 is shown on the back contact layer 22.

Other components (not shown) can be included in the exemplary module 10, such as bus bars, external wiring, laser etches, etc. The module 10 may be divided into a plurality of individual cells that are connected in series in order to achieve a desired voltage, such as through an electrical wiring connection. Each end of the series connected cells can be attached to a suitable conductor, such as a wire or bus bar, to direct the photovoltaically generated current to convenient locations for connection to a device or other system using the generated electric. A convenient means for achieving the series connected cells is to laser scribe the module 10 to divide the device into a series of cells connected by interconnects. Also, electrical wires can be connected to positive and negative terminals of the PV module 10 to provide lead wires to harness electrical current produced by the PV module 10.

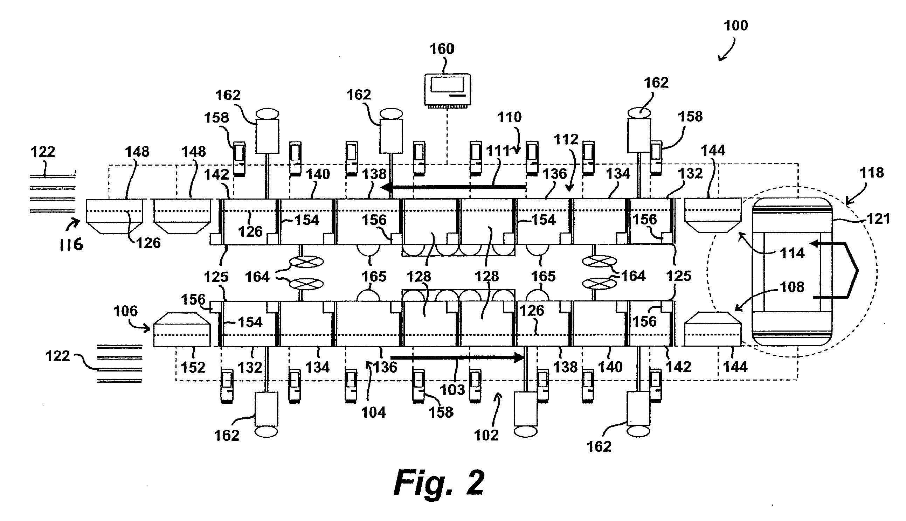

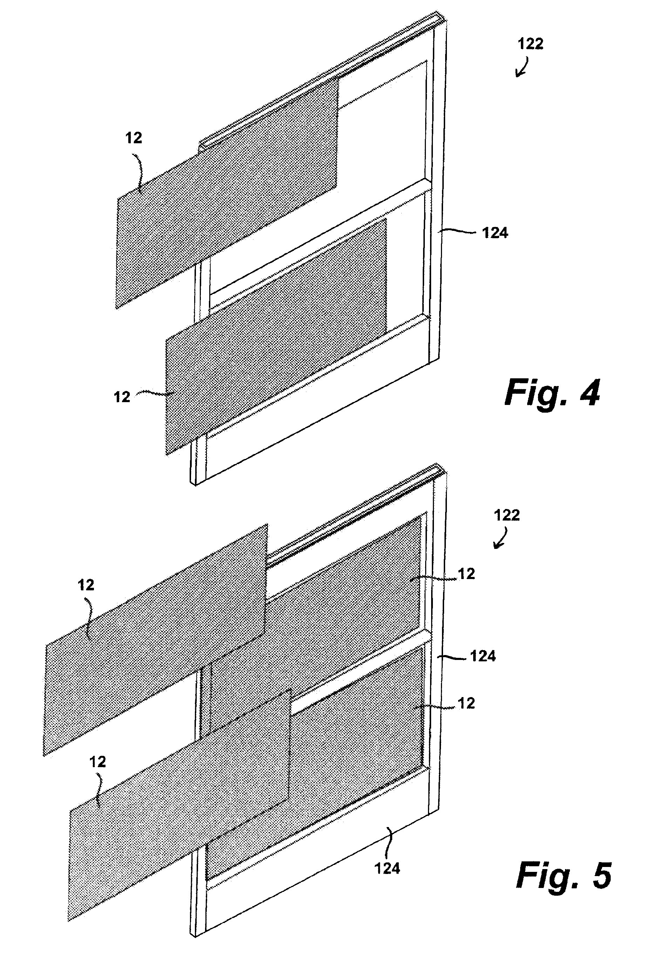

Fig. 2 represents an exemplary system 100 in accordance with aspects of the invention for deposition of multiple thin film layers on PV module substrates 12 (Fig. 4) that are conveyed through the system 100. As a first matter, it should be noted that the system 100 is not limited by any particular type of thin film or thin film deposition process, as described in greater detail herein.

The illustrated system 100 includes a first processing side 102 wherein substrates loaded onto carriers 122 are conveyed in a first direction indicated by the arrow 103. First processing side 102 includes a plurality of different processing stations 104 that are configured for deposition of a first thin film layer on the substrates as the substrates are conveyed along the first processing side 102. The processing stations 104 may include serially arranged modular units that are aligned to carry out all of the processing steps necessary for deposition of the first film layer on the substrates. The carriers 122 having one or more substrates loaded thereon are introduced into the first processing side 102 at an entry location 106. The carriers 122 may be manually loaded into a load station 152 or, in an alternative embodiment, automated machinery may be used for introducing the carriers 122 into the load station 152. For example, robots or other automated machinery may be used for this process.

The carriers 122 are removed from the first processing side 102 at an opposite exit location 108, which may include an external buffer 144. Again, the carriers 122 may be manually unloaded or received by automated moving equipment, including robotic machines and the like.

The system 100 includes a second processing side 110 that is operably disposed relative to the first processing side 102 so as to convey the carriers 122 (and substrates carried thereby) that exit the first processing side 102 in a second direction indicated by the directional arrow 111 through the second processing side 110. The second processing side 110 includes a plurality of processing stations 112 that are configured and serially arranged for deposition of a second thin film layer on the first thin film layer. As with the first processing side 102, the processing modules 112 along the second processing side 110 are configured for carrying out all of the processing steps necessary for deposition of the thin film layer as the carriers 122 and substrates are conveyed through the second processing side 110.

A first transfer station 118 is operably disposed between the first processing side 102 and the second processing side 110 to receive the substrates from the exit 108 of the first processing side 102 and to automatically move the substrates to an entry 114 to the second processing side 110. The transfer station 118 may include any manner of automated machinery for accomplishing the transfer of the carriers 122. For example, the transfer station 118 may include an automated turntable 121 that is configured to receive a carrier 122 from the exit 108 of the first processing side 102, rotate counterclockwise 180°, and to introduce the carrier 122 at the entry 144 of the second processing side 110. The turntable 121 may include any manner of robotic or other automated machinery for this purpose. In an alternative embodiment, the transfer station 118 may include any manner of conveyors that accomplish the task of receiving and conveying the carriers 122 from the exit 108 of the first processing side 102 to the entry 144 of the second processing side 110. It should be readily appreciated that any manner of transfer and conveying configuration may be utilized for this purpose.

In the illustrated embodiments, the first processing side 102 and second processing side 110 are essentially parallel to each others such that the direction of conveyance 103 and 111 of the respective processing sides are essentially parallel and opposite in direction. This arrangement may be beneficial from the standpoint of saving space in a production facility. However, it should be readily appreciated, that the second conveying direction may be disposed at any relative operational angle with respect to the axis of the first processing station 102 (including an in-line or zero angle), and that the invention is not limited to the configuration illustrated in the figures.

With the overall configuration illustrated in Fig. 2, it should readily be appreciated that the carriers 122 (with substrates) are continuously moved through the first and second processing sides 102, 110 for deposition of multiple thin film layers thereon. The configuration of Fig. 2 is an open-ended loop configuration wherein the carriers 122 are external to the system and introduced into the first processing side 102 at the entry location 106. The carriers are subsequently removed from the system 100 at the exit location 116 of the second processing side 110. This load and unload process may be done manually or by automated machinery, as mentioned above.

Still referring to Fig. 2, the various processing stations 104, 112 may be defined by vertical processing modules 125, with each of the adjacently aligned modules 125 serving a particular processing function, as described in greater detail below. Each of the modules 125 may include an independently driven and controlled conveyor 126. The substrate carriers 122 rest on the conveyors 126 and are thereby moved in a controlled manner through the respective modules 125. In particular embodiments, the conveyors 126 may be roller-type conveyors, belt conveyors, and the like. The conveyors 126 for each of the respective modules 125 may be provided with an independent drive (not illustrated in the figure). In an alternative embodiment, a drive may be configured for driving multiple conveyors 126 of different modules 125 through any manner of gearing arrangement. A single conveyor 126 may be associated with multiple modules 125.

The various modules 125 are vertically oriented in that the carriers 122 convey the substrates in a vertical orientation through the processing sides 102, 110. Referring to Fig. 4, an exemplary carrier 122 is illustrated as a frame-type of structure made from frame members 124. The frame members 124 define receipt positions for substrates 12 such that the substrates 12 are horizontally or vertically received (relative to their longitudinal axis) within the carrier 122. It should be appreciated that the carrier 122 may be defined by any manner of frame structure or members so as to carry one or more of the substrates 12 in a vertical orientation through the processing sides. In the embodiment of Fig. 4, the carrier 122 is configured for receipt of two substrates 12 in a horizontal position. It should be readily appreciated that the multiple substrates 12 could also be disposed such that the longitudinal axis of the respective substrates is in a vertical position. Any orientation of the substrates 12 within the carrier 122 is contemplated within the scope and spirit of the invention. The frame members 124 may define an open-type of frame wherein the substrates 12 are essentially received within a "window opening" defined by the carrier 122. In an alternative embodiment, the carrier 122 may define a back panel against which the substrates 12 are disposed.

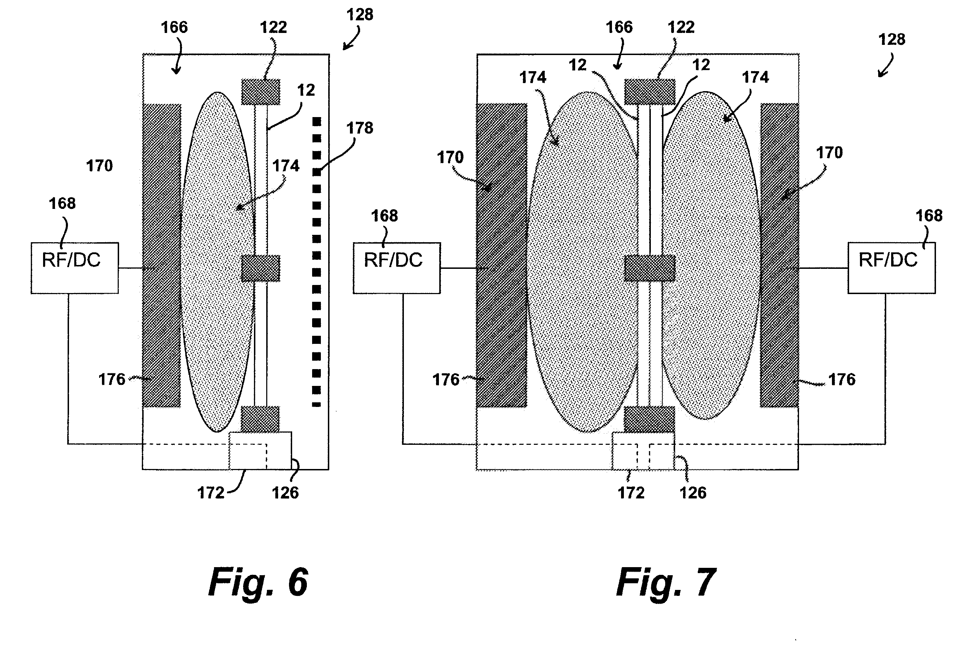

The embodiment of the carrier 122 illustrated in Fig. 5 is configured for receipt of four substrates 112, wherein pairs of the substrates 12 are in a back-to-back relationship. For example, a pair of the substrates 12 is disposed in the upper frame portion of the carrier 112, and a second pair of the substrates 12 is disposed in the lower frame portion of the carrier 112. The configuration of Fig. 5 may be used when four or more of the substrates 12 are simultaneously processed in the system 100, as described in greater detail below with respect to the deposition apparatus illustrated in Fig. 7.

Referring again to Fig. 2, the first processing side 108 may be particularly configured with one or more vertical deposition modules 128 that define a vacuum sputtering chamber for deposition of a zinc-tin oxide (ZTO) layer on the substrates conveyed therethrough. Likewise, the second processing side 110 may include one or more vertical deposition modules 128 that define a vacuum sputtering chamber particularly configured for deposition of a cadmium sulfide (CDS) layer on the ZTO layer. Operation of vacuum sputtering chambers is well known to those skilled in the art and need not be described in detail herein. Basically, sputtering deposition generally involves ejecting material from a target, which is the material source, and depositing the ejected material onto the substrate in the form of a thin film layer. DC sputtering generally involves applying a voltage to a metal target (i.e., the cathode) positioned near the substrate within a chamber to form a direct-current discharge. The sputtering chamber can have a reactive atmosphere (e.g., an oxygen atmosphere) that forms a plasma field between the metal target and the substrate. The pressure of the reactive atmosphere can be between about 1 mtorr and about 20 mtorr for magnetron sputtering. When metal atoms are released from the target upon application of the voltage, the metal atoms react with the plasma and deposit onto the surface of the substrate. For example, when the atmosphere contains oxygen, the metal atoms released from the metal target form a metallic oxide layer on the substrate. RF sputtering is a process that involves exciting a capacitive discharge by applying an alternating current (AC) or radio-frequency (RF) signal between the target source material and the substrate. The sputtering chamber may have an inert atmosphere (e.g., an argon atmosphere) having a pressure between about 1mtorr and about 20mtorr.

Fig. 6 shows a general schematic cross-sectional view of an exemplary vertical deposition module 128 configured as an RF or DC sputtering chamber 166. A power source 168 is configured to control and supply DC or RF power to the chamber 166. In the case of a DC chamber 166, the power source 168 applies a voltage to the cathode 170 to create a voltage potential between the cathode 170 and an anode 172.

In the illustrated embodiment, the anode 172 is defined by the chamber wall. The glass substrates 12 are held by the carrier 122 so as to be generally opposite from the cathode 170 (which is also the target source material 176). A plasma field 174 is created once the sputtering atmosphere is ignited and is sustained in response to the voltage potential between the cathode 170 and the chamber wall acting as the anode 172. The voltage potential causes the plasma ions within the plasma field 174 to accelerate towards the cathode 170, causing atoms from the cathode 170 to be ejected towards the surface of the substrates 12. As such, the cathode 170 is the "target" and is defined by the source material for formation of the particular type of thin film desired on the surface of the substrates 12. For example, the cathode 170 can be a metal alloy target, such as elemental tin, elemental zinc, or mixtures of different metal alloys. Oxygen in the chamber 166 reacts with the ejected target atoms to form an oxide layer on the substrates 12, such as a ZTO layer.

A cadmium sulfide (CdS) thin film layer may be formed in an RF sputtering chamber 166 (Fig. 6) by applying an alternating-current (AC) or radial-frequency (RF) signal between a ceramic target source material and the substrates 12 in an essentially inert atmosphere.

Although single power sources are illustrated in Figs. 6 and 7, it is generally understood that multiple power sources may be coupled together with a respective target source for generating the desired sputtering conditions within the chamber 166.

Fig. 6 illustrates a heater element 178 within the chamber 166. Any manner or configuration of heater elements may be configured within the chamber 166 to maintain a desired deposition temperature and atmosphere within the chamber.

In the embodiment of Fig. 6, the vertical deposition module 128 is configured for deposition of a thin film layer on the side of the substrates 12 oriented towards the target source material 176. Fig. 7 illustrates an embodiment wherein the chamber 166 includes dual sputtering systems for applying a thin film onto the outwardly facing surfaces of the back-to-back substrates 12 secured in the carriers 122, such as the carrier 122 configuration illustrated and described above with respect to Fig. 5. Thus, with the vertical deposition module 128 illustrated in Fig. 7, four substrates are simultaneously processed for deposition of a particular thin film layer thereon.

Referring again to the system 100 in Fig. 2, the individual conveyors 126 associated with the adjacently disposed vertical deposition modules 128 are controlled so as to convey the carriers 122 and attached substrates through the vacuum sputtering chambers at a controlled, constant linear speed to ensure an even deposition of the thin film onto the surface of the substrates. On the other hand, the carriers 122 and substrates are introduced in a step-wise manner into and out of the respective processing sides 102, 110. In this regard, the system 100 includes any configuration of entry and exit modules, associated conveyors 126, and vacuum lock valves 154 with associated controllers 156. In addition, the respective processing sides 102, 110 may include additional non-vacuum modules at the respective entry and exit sides thereof for loading the carriers 112 into and out of the system 100, buffering the carriers 122 relative to the transfer station 118, and cooling-down the substrates and carriers 122 prior to removal of the substrates from the system 100.

For example, referring to Fig. 2, the first processing side 102 includes a plurality of adjacently disposed vertical processing modules 125. A first one of these modules 125 defines a load station 152 wherein the carriers 122 are loaded into the system. As mentioned, this may be done manually or robotically. A respective conveyor within the load station 152 module moves the carriers 122 to a vacuum load module 132. This module 132 includes an entry vacuum valve 154, which may be, for example, a gate-type slit valve or rotary-flapper valve that is actuated by an associated motor 156. The initial valve 154 is open and a carrier 122 is conveyed into the module 132 from the load module 152. The entry valve 154 is then closed. At this point, a "rough" vacuum pump 162 pumps from atmosphere to an initial "rough" vacuum in the millitorr range. The rough vacuum pump 162 may be, for example, a claw-type mechanical pump with a roots-type blower. Upon pumping to a defined crossover pressure, the valve 154 between the load module 132 and an adjacent load buffer module 134 is opened and the carrier 122 is transferred into the load buffer module 134. The valve 154 between the modules 132 and 134 is then closed, the load module 132 is vented, and the initial valve 154 is opened for receipt of the next carrier 122 into the module. A "high" or "fine" vacuum pump 164 draws an increased vacuum in the load buffer module 134, and the module 134 may be backfilled with process gas to match the conditions in the downstream processing chambers. The fine vacuum pump 164 may be, for example, a combination of cryopumps configured for pumping down the module to about less than or equal to 9x10⁻⁵ torr.

A process buffer module 136 is downstream of the load buffer module 134 and at the prescribed vacuum pressure and conditions within the load buffer module 134, the valve 154 between these two modules is opened and the carrier 122 is conveyed into the process buffer module 136. The valve 154 between the modules 134 and 136 is then closed. The process buffer module 136 serves to essentially convert the step-wise conveyance of the carriers 122 into a controlled linear conveyance such that the leading edge of the carrier 122 is within a narrow, defined space or distance (i.e., about 20 mm) from the trailing edge of the previous carrier 122 so that the carriers 122 are conveyed through the downstream deposition modules 128 at a controlled, constant linear speed with little space between the respective carriers 122. It should thus be appreciated that, during normal production operations, the valve 154 between the process buffer module 136 and first vertical deposition module 128 is opened. Likewise, the valve 154 between the adjacent vertical deposition modules 128 is also opened. The valve 154 at the exit of the second vertical deposition module 128 is also opened. In this manner, a continuous flow of the carriers 122 through the adjacently disposed vertical deposition modules 128 at a constant processing speed is maintained.

Still referring to Fig. 2, an after-process buffer module 138 is disposed downstream of the last vertical deposition module 128 and the valve 154 between these modules is opened during normal processing. As the carriers 122 leave the vertical deposition module 128 at a controlled constant linear speed, they enter the after-process buffer module 138 and are then processed at a greater speed towards the immediately downstream exit buffer module 140. Prior to this conveyance step, the valve 154 between the modules 138 and 140 is closed and the module 140 is drawn down by the fine vacuum pump 164 and backfilled with process gas to match the processing zone conditions. Once these conditions are met, the valve 154 between the chambers is opened and the carrier 122 is transferred at a relatively higher speed into the exit buffer module 140. At a predefined crossover pressure between the module 140 and a downstream exit module 142 (which may be achieved within the module 142 by a rough vacuum pump 162), the respective valve 154 between these modules is opened and the carrier 122 is conveyed into the exit module 142. The exit module 142 may then be vented to atmosphere. At this point, the valve 154 at the exit of the module 142 is opened and the carrier 122 is conveyed into an external buffer 144.

From the external buffer 144, the carriers 122 are moved into the turntable 121 or other transfer mechanism configured at the transfer station 118. The carriers are rotated or otherwise moved at the transfer station 118 to a position for entry into an external buffer 144 at the entry point of the second processing side 110.

The process buffer module 136 and the after-process buffer module 138 may include one or more respective vacuum pump 165, such as a turbomolecular pump, mounted directly to the back of the modules for maintaining the processing vacuum pressures. Likewise, the vertical deposition modules 128 may also include any manner of vacuum pumps, such as turbomolecular pumps 165 mounted directly to the back of the modules between each of the cathode pairs associated with the respective modules.

Referring again to the system 100 of Fig. 2, the carriers 122 that are transferred to the external buffer 144 associated with the second processing side 110 are subsequently conveyed through the various vertical processing modules 125 in essentially the same manner as discussed above with respect to the first processing side 102. The operation and sequence of the various valves 154, pumps 162, 164, 165, and respective conveyors 126 is as described above for the purpose of stepping the carriers 122 in a step-wise manner into the processing modules wherein the carriers 122 are then conveyed at a constant linear speed through the vertical deposition modules 128. The vertical deposition modules 128 in the second processing side 110 are configured for deposition of a second thin film layer on the first thin film layer, for example a CdS layer, as described above.

After exiting the exit module 142 of the second processing side 110, the carriers 122 are moved into one or more cool-down stations 148 wherein the carriers and attached substrates are allowed to cool to a desired handling temperature prior to being removed from the system 100. The removal process may be manual or automated, for example with robotic machinery.

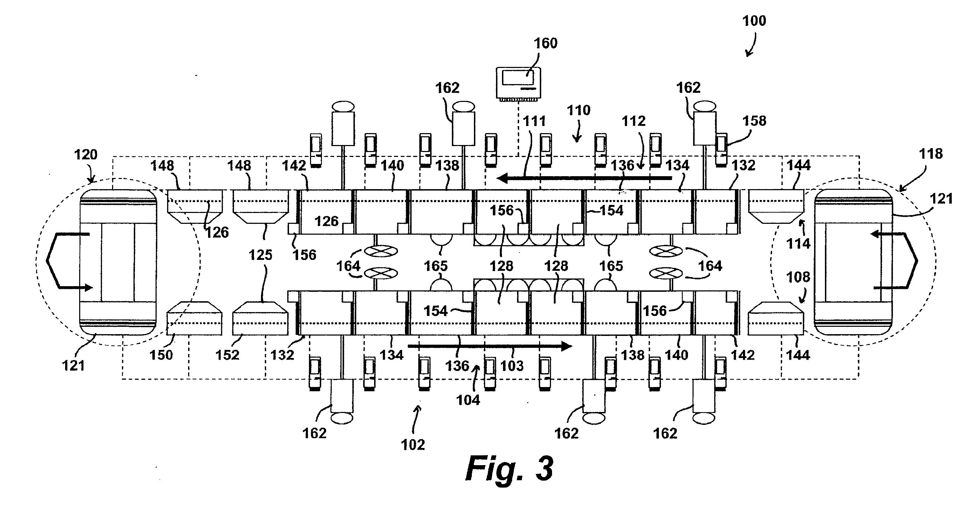

The system 100 in Figs. 2 and 3 are defined by a plurality of interconnected modules, as discussed above, with each of the modules serving a particular function. The respective conveyors 126 configured with the individual modules are also appropriately controlled for various functions, as well as the valves 154 and associated actuators 156. For control purposes, each of the individual modules may have an associated controller 158 configured therewith to control the individual functions of the respective module. The plurality of controllers 158 may, in turn, be in communication with a central system controller 160. The central system controller 160 can monitor and control (via the independent controllers 158) the functions of any one of the modules so as to achieve an overall desired conveyance rate and processing of the substrates carried by the carriers 122 as they move through the system 100.

It should be readily appreciated that, although the deposition modules 128 are described herein in particular embodiments as sputtering deposition modules, the invention is not limited to this particular deposition process. The vertical deposition modules 128 may be configured as any other suitable type of processing chamber, such as a chemical vapor deposition chamber, thermal evaporation chamber, physical vapor deposition chamber, and so forth. In the particular embodiments described herein, the first processing side may be configured for deposition of a ZTO layer, with the vertical deposition modules 128 configured as reactive (using oxygen) DC vacuum sputtering chambers. Each module 128 may be configured with four DC water-cooled magnetrons. As mentioned above, each module 128 may also include one or more vacuum pumps mounted on the back chambers between each cathode pair. The vertical deposition modules 128 associated with the second processing side 110 may be configured as RF vacuum sputtering chambers, with each module 128 including three RF water-cooled magnetrons for deposition of a CdS layer from a CdS ceramic target material. These modules 128 also may include one or more vacuum pumps mounted between the cathode pairs.

Fig. 3 illustrates an alternative system 100 that is similar to the system of Fig. 2, but includes a second transfer station 120 between the exit of the second processing side 110 and the entry of the first processing side 102. This particular system thus defines a continuous loop wherein the carriers 122 are continuously conveyed in a processing loop through the system. The carriers 122 move out of the exit module 142 of the second processing station 110 and through the cool-down stations 148. The carriers 122 then move into the second transfer station 120, which may be configured as discussed above with respect to the first transfer station 118. The carriers are transferred from the last cool-down station 148 to an unload station 150 aligned with the first processing side 102. As the carriers 122 move through the unload station 150, the substrates are removed from the carriers. Again, this process may be manual or accomplished via automated robotic machinery. The empty carriers then move into a load station 152 wherein new substrates are loaded into the carriers 122. The carriers 122 and associated substrates are then processed through the first and second processing sides 102, 110, as discussed above with respect to Fig. 2. The system 100 in Fig. 3 is unique in that the process is carried out in a continuous-loop manner wherein the carriers 122 need not be removed from the system. The efficiency and through-put of the system may be significantly increased with the configuration of Fig. 3.

The through-put of the system 100 depicted in Figs. 2 and 3 may be further increased by utilization of vertical deposition modules 128 as depicted in Fig. 7 wherein the modules 128 are essentially a combination of two separate chambers configured in facing relationship so as to deposit the thin-film layers on the surfaces of back-to-back substrates mounted within the carriers 122, as depicted in the carrier configuration of Fig. 5.

In the system 100 embodiments of Figs. 2 and 3, a processing vacuum is separately drawn and maintained in the respective processing sides 102, 110. The carriers are removed from the vacuum processing modules 125 along the first processing side 102, transferred to the second processing side 110, and introduced into the vacuum processing modules 125 of the second processing side 110 as discussed above. It should be readily appreciated that the invention also encompasses systems 100 wherein an overall vacuum is maintained between the first processing side 102 and second processing side 110. In such a system, the carriers 122 would be buffered and transferred from one processing side to the other within a vacuum chamber.

The present invention also encompasses various process embodiments for deposition of multiple thin film layers on a photovoltaic (PV) module substrate. The processes may be practiced with the various system embodiments described above or by any other configuration of suitable system components. It should thus be appreciated that the process embodiments according to the invention are not limited to the system configuration described herein.

In a particular embodiment, the process includes conveying the substrates on carriers in a first direction through a first processing side and depositing a first thin film layer on the substrates as they move through the first processing side. The carriers are received at the exit of the first processing side and are moved to the entry of a second processing side. The carriers and attached substrates are then conveyed through the second processing side for deposition of a second thin film layer on the first thin film layer. The substrates are removed from the carriers at an unload station downstream of an exit from the second processing side and new substrates are placed onto the carriers at a load station upstream of the entry to the first processing side.

The process may include moving the carriers and attached substrates into and out of vacuum chambers along the first and second processing sides in a step-wise manner, for example through a series of vacuum locks, yet conveying the carriers and attached substrates through the vacuum chambers at a continuous linear speed during the deposition process.

In a particular embodiment, the first and second processing sides are generally parallel and the carriers are moved in a continuous loop through the first and second processing sides, with the unload and load stations being adjacent within the continuous loop.

In another embodiment, the first and second processing sides are generally parallel and the carriers are loaded at an entry to the first processing side and removed at an exit of the second processing side.

In still another process embodiment, the thin film layers are deposited within vacuum chambers defined along the first and second processing stations, and the carriers and attached substrates are moved through the system without breaking vacuum between the first and second processing sides.

This written description uses examples to disclose the invention, including the preferred mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

Various aspects and embodiments of the present invention are defined by the following numbered clauses:
1. A system for deposition of multiple thin film layers on photovoltaic (PV) module substrates, comprising:
   a first processing side wherein the substrates are conveyed in a first direction, said first processing side further comprising processing stations configured for deposition of a first thin film layer on the substrates;
   a second processing side operably disposed relative to said first processing side such that substrates exiting said first processing side are subsequently conveyed in a second direction through said second processing side, said second processing side further comprising processing stations configured for deposition of a second thin film layer on said first thin film layer; and,
   a first transfer station operably disposed between said first processing side and said second processing side to receive the substrates from an exit of said first processing side and introduce the substrates into an entry of said second processing side;
   wherein the substrates are continuously moved through said first and second processing sides for deposition of multiple thin film layers thereon.
2. The system as in clause 1, further comprising a plurality of carriers onto which the substrates are loaded for conveyance through said system, and said first and second processing sides further comprising driven conveyors configured for conveying said carriers through said respective processing stations.
3. The system as in any preceding clause, wherein said carriers and attached substrates are conveyed in a vertical orientation through said first and second processing sides, said respective processing stations along said first and second processing sides comprising vertical processing modules.
4. The system as in any preceding clause, wherein said vertical processing modules along said first processing side comprise at least one vertical deposition module that defines a vacuum sputtering chamber configured for deposition of a zinc-tin oxide (ZTO) layer on said substrate, and said vertical processing modules along said second processing side comprise at least one vertical deposition module that defines a vacuum sputtering chamber configured for deposition of a cadmium sulfide (CdS) layer onto the ZTO layer.
5. The system as in any preceding clause, wherein said vertical processing modules along said first and second processing sides comprise vacuum entry and exit modules configured for conveying the substrates into and out of said vacuum sputtering chambers in a stepped manner.
6. The system as in any preceding clause, wherein said driven conveyors of said vertical processing modules along said first and second processing sides are configured for conveying said carriers and attached substrates through said vacuum sputtering chambers at a constant linear speed.
7. The system as in any preceding clause, wherein said transfer station comprises a turntable operably configured between said exit of said first processing side and said entry of said second processing side.
8. The system as in any preceding clause, wherein said respective processing stations along said first and second processing sides comprise a plurality of vertical processing modules, each of said vertical processing modules comprising an individually driven conveyor, and further comprising a plurality of carriers onto which the substrates are loaded for conveyance through said system, said carriers engaged and driven by said individual conveyors as said carriers are moved along adjacent said vertical processing modules, said conveyors individually controlled so that the substrates are conveyed through said first and second processing sides at a desired heating rate, film deposition rate, and cool down rate.
9. The system as in any preceding clause, wherein said vertical processing modules include at least one single chamber vertical deposition module configured for depositing the thin film layers onto an exposed surface of the substrates conveyed therethrough.
10. The system as in any preceding clause, wherein said carriers are configured for back-to-back loading of substrates thereon, said vertical processing modules including at least one dual chamber vertical deposition module configured for simultaneous deposition of the thin film layers onto exposed surfaces of the back-to-back substrates.
11. The system as in any preceding clause, further comprising a second transfer station operably disposed between an exit of said second processing side and an entry to said first processing side such that said system is configured as a continuous loop.
12. The system as in any preceding clause, further comprising a plurality of carriers onto which the substrates are loaded for conveyance through said system, said carriers conveyed continuously through said continuous loop.
13. A process for deposition of multiple thin film layers on a photovoltaic (PV) module substrate, comprising:
   conveying the substrates on carriers in a first direction through a first processing side;
   depositing a first thin film layer on the substrates as they move through the first processing side;
   receiving the carriers at an exit of the first processing side;
   moving the carriers with attached substrates to an entry of a second processing side;
   conveying the carriers and attached substrates in a second direction through the second processing side;
   depositing a second thin film layer on the first thin film layer as the carriers and attached substrates are moved through the second processing side;
   removing the substrates from the carriers at an unload station downstream of an exit from the second processing side; and,
   placing new substrates onto the carriers at a load station downstream of the unload station and upstream of an entry to the first processing side.
14. The process as in any preceding clause, wherein the thin film layers are deposited within vacuum chambers defined along the first and second processing sides, said process further comprising:
   moving the carriers and attached substrates into and out of the vacuum chambers in a step-wise manner; and,
   conveying the carriers and attached substrates through the vacuum chambers in a continuous linear speed.
15. The process as in any preceding clause, wherein the carriers and attached substrates are vertically oriented, the thin film layers being deposited in vertical sputtering deposition processes along the first and second processing sides.
16. The process as in any preceding clause, wherein the substrates are loaded on the carriers in a back-to-back orientation and thin film layers are simultaneously deposited onto the exposed surfaces of the back-to-back substrates in a dual chamber vertical sputtering process.
17. The process as in any preceding clause, wherein the first and second processing sides are generally parallel and the carriers are moved in a continuous loop through the first and second processing sides, the unload and load stations being adjacent within the continuous loop.
18. The process as in any preceding clause, wherein the first and second processing sides are generally parallel and the carriers are loaded at an entry to the first processing side and removed at an exit of the second processing side.
19. The process as in any preceding clause, wherein the first processing side deposits a zinc tin oxide (ZTO) layer on the substrates in a vertical planar sputtering process, and the second processing side deposits a cadmium sulfide (CdS) layer on the ZTO layer in a vertical planar sputtering process.
20. The process as in any preceding clause, wherein the thin film layers are deposited within vacuum chambers defined along the first and second processing sides, said process further comprising moving the carriers and attached substrates into and through the vacuum chambers without breaking vacuum between the first and second processing sides.

## Claims

1. A system (100) for deposition of multiple thin film layers on photovoltaic (PV) module substrates (12), comprising:
a first processing side (102) wherein the substrates are conveyed in a first direction (103), said first processing side further comprising processing stations (104) configured for deposition of a first thin film layer on the substrates;
a second processing side (110) operably disposed relative to said first processing side such that substrates exiting said first processing side are subsequently conveyed in a second direction (111) through said second processing side, said second processing side further comprising processing stations (112) configured for deposition of a second thin film layer on said first thin film layer; and
a first transfer station (118) operably disposed between said first processing side and said second processing side to receive the substrates from an exit (108) of said first processing side and introduce the substrates into an entry (114) of said second processing side;
wherein the substrates are continuously moved through said first and second processing sides for deposition of multiple thin film layers thereon.

2. The system (100) as in claim 1, further comprising a plurality of carriers (122) onto which the substrates (12) are loaded for conveyance through said system in a vertical orientation, said respective processing stations (104, 112) along said first and second processing sides (102, 110) comprising vertical processing modules (125).

3. The system (100) as in claim 2, wherein said vertical processing modules (125) along said first processing side (102) comprise at least one vertical deposition module (128) that defines a vacuum sputtering chamber (166) configured for deposition of a zinc-tin oxide (ZTO) layer on said substrate (12), and said vertical processing modules (125) along said second processing side (110) comprise at least one vertical deposition module (128) that defines a vacuum sputtering chamber (166) configured for deposition of a cadmium sulfide (CdS) layer onto the ZTO layer.

4. The system (100) as in claim 2 or claim 3, further comprising driven conveyors (126) in said vertical processing modules (128) along said first and second processing sides (102, 110) configured for conveying said carriers (122) and attached substrates (12) through said vacuum sputtering chambers (166) at a constant linear speed.

5. The system (100) as in any preceding claim, wherein said respective processing stations (104, 112) along said first and second processing sides (102, 110) comprise a plurality of vertical processing modules (125), each of said vertical processing modules comprising an individually driven conveyor (126), and further comprising a plurality of carriers (122) onto which the substrates (12) are loaded for conveyance through said system, said carriers engaged and driven by said individual conveyors as said carriers are moved along adjacent said vertical processing modules, said conveyors individually controlled so that the substrates are conveyed through said first and second processing sides at a desired heating rate, film deposition rate, and cool down rate.

6. The system (100) as in claim 5, wherein said carriers (122) are configured for back-to-back loading of substrates (12) thereon, said vertical processing modules (125) including at least one dual chamber vertical deposition module configured for simultaneous deposition of the thin film layers onto exposed surfaces of the back-to-back substrates.

7. The system (100) as in any preceding claim, further comprising a second transfer station (120) operably disposed between an exit (116) of said second processing side (110) and an entry (106) to said first processing side (102) such that said system is configured as a continuous loop.

8. A process for deposition of multiple thin film layers on a photovoltaic (PV) module substrate (12), comprising:
conveying the substrates on carriers (122) in a first direction (103) through a first processing side (102);
depositing a first thin film layer on the substrates as they move through the first processing side;
receiving the carriers at an exit (108) of the first processing side;
moving the carriers with attached substrates to an entry (114) of a second processing side (110);
conveying the carriers and attached substrates in a second direction (111) through the second processing side;
depositing a second thin film layer on the first thin film layer as the carriers and attached substrates are moved through the second processing side;
removing the substrates from the carriers at an unload station (150) downstream of an exit (116) from the second processing side; and
placing new substrates onto the carriers at a load station (152) downstream of the unload station and upstream of an entry to the first processing side.

9. The process as in claim 8, wherein the thin film layers are deposited within vacuum chambers (125, 128) defined along the first and second processing sides (102, 110), said process further comprising:
vertically orienting the carriers (122) and attached substrates (12) and depositing the thin film layers in vertical sputtering deposition processes along the first and second processing sides;
moving the carriers and attached substrates into and out of the vacuum chambers in a step-wise manner; and
conveying the carriers and attached substrates through the vacuum chambers at a continuous linear speed.

10. The process as in claim 8 or claim 9, wherein the carriers (122) are moved in a continuous loop through the first and second processing sides (102, 110) and through the vacuum chambers (125, 128) without breaking vacuum between the first and second processing sides, the unload and load stations being adjacent within the continuous loop.
